# EUROPEAN PATENT SPECIFICATION

(11) **EP 2 644 752 B1**
(45) Date of publication and mention of the grant of the patent: **20.04.2016**
(21) Application number: 13156482.5
(22) Date of filing: 22.02.2013
(51) Int. Cl.: C25D 7/00, C25D 11/02, C25D 11/16, C25D 11/24, H05K 5/04, H05K 13/00

(54) **Casing of electronic device and method of manufacturing the same**
Gehäuse für eine elektronische Vorrichtung und Herstellungsverfahren dafür
Boîte de dispositif électronique et son procédé de fabrication

(30) Priority: 24.02.2012 US 201261602626 P; 21.11.2012 US 201213684076
(43) Date of publication of application: 02.10.2013
(73) Proprietor: HTC Corporation, Taoyuan City 330 (TW)
(72) Inventor: Liou, Jethro, San Francisco, CA California 94110 (US); Chang, Feng-Chen, 330 Taoyuan City (TW); Chien, Chih-Ling, 330 Taoyuan City (TW)
(74) Representative: Harrasz, Julia Konstanze

(56) References cited:
- EP-A1- 2 371 996
- EP-A2- 1 980 651
- WO-A1-84/04549
- WO-A1-94/21387
- US-A- 3 909 387
- US-A- 5 290 424
- US-A1- 2004 040 854
- US-A1- 2009 041 988
- US-A1- 2009 047 505
- US-A1- 2009 324 840
- US-A1- 2010 112 297
- US-A1- 2010 112 298

## Description

### BACKGROUND

### Technical Field

The application relates to a casing and a manufacturing method of a casing, and more particularly, to a casing of electronic device and a manufacturing method of a casing of electronic device.

### Description of Related Art

In recent years, as the technology industry becomes increasingly developed, electronic products provide users with the desired information that is easily accessible in everyday life. On the other hand, electronic devices are developing toward a convenient, multi-functional, and aesthetic design direction to provide users with more options. At the same time, electronic products are gradually developing toward a slim and light trend, therefore gradually increasing the demand of electronic devices.

Electronic devices are, for instance, mobile phones, Personal Digital Assistants (PDAs), and smart phones, and these electronic devices usually have the advantages of small size and lightweight. Users may carry the electronic devices around, and may operate the electronic devices by holding them. Therefore, electronic devices are very convenient.

However, the casing of electronic device becomes damaged easily during use from bumping, or the surface of the casing of electronic device becomes scratched from contact with sharp metal objects such as keys. Moreover, when users hold electronic devices frequently, fingerprints and dirt from the hands of the users easily remain on the surfaces of the electronic devices. Methods are known to protect the metal surfaces, e.g. the external surfaces of electronic devices. US 3.909.387 shows an apparatus for producing polymer coated aluminium products. Us 5,290.424 discloses a method for double protecting aluminium products with oxide and fluoropolymer coatings, and US 2009/0324848 discloses a process for sealing micro pores of an micro-oxide film on a piece of metal with an epoxy resin.

### SUMMARY

The application provides a manufacturing method of a casing of electronic device that enhances the mechanical strength of the casing of electronic device as defined in the claims.

The application provides a casing of electronic device having higher mechanical strength as defined in the claims.

The application provides a manufacturing method of a casing of electronic device including the following steps. A casing body is provided, and the material of the casing body being metal. An oxide ceramic layer is formed on a surface of the casing body, wherein the step of forming the oxide ceramic layer on the surface of the casing body is a Micro Arc Oxidation (MAO) process. An anti-fingerprint layer (AFP layer) is formed on the oxide ceramic layer after the step of forming the oxide ceramic layer, wherein AFP layer comprises 15-25% Xylene, 5-15% 2-butoxyethanol, 5-15% Methyl ethyl ketone, 5-15% Toluene, 5-15% 2-methylpropanol, 1-5% Ethylbenzene, 1-5% Epoxy resin, 1-5% Methyl isobutyl ketone. The surface of the casing body is roughend, and the oxide ceramic layer is formed on the roughened surface of the casing body.

The application further provides a casing of electronic device including a casing body and an oxide ceramic layer and an AFP layer. The material of the casing body is metal. The oxide ceramic layer is located on a roughened surface of the casing body. The AFP layer is located on the oxide ceramic layer and comprises 15-25% Xylene, 5-15% 2-butoxyethanol, 5-15% Methyl ethyl ketone, 5-15% Toluene, 5-15% 2-methylpropanol, 1-5% Ethylbenzene, 1-5% Epoxy resin, 1-5% Methyl isobutyl ketone.

In summary, the application provides a manufacturing method of a casing of electronic device, wherein an oxide ceramic layer is formed on the metal casing body by the Micro Arc Oxidation process to enhance the mechanical strength of the casing of electronic device. Moreover, the application further provides a casing of electronic device having an oxide ceramic layer located on the surface of the casing body. Accordingly, the casing of electronic device has higher mechanical strength.

In order to make the aforementioned features and advantages of the application more comprehensible, embodiments accompanied with figures are described in detail below.

### BRIEF DESCRIPTION OF THE DRAWINGS

The accompanying drawings are included to provide a further understanding of the application, and are incorporated in and constitute a part of this specification. The drawings illustrate embodiments of the application and, together with the description, serve to explain the principles of the application.
FIG. 1 is a flow chart of the manufacturing method of the casing of electronic device according to an embodiment of the application.
FIG. 2A to FIG. 2D are cross-sectional schematic diagrams of the manufacturing method of the casing of electronic device of FIG. 1.
FIG. 3 is a cross-sectional schematic diagram of the casing of electronic device according to another embodiment of the application.

### DESCRIPTION

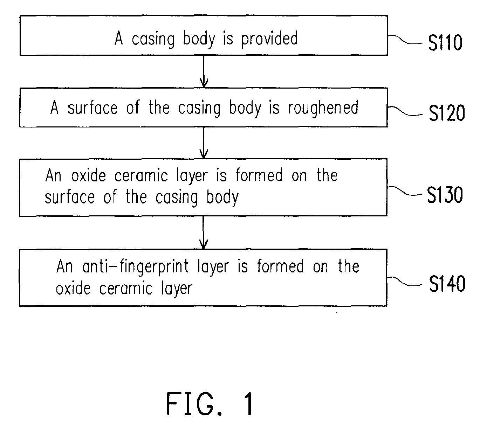

FIG. 1 is a flow chart of the manufacturing method of the casing of electronic device according to an embodiment of the application. Referring to FIG. 1, in the embodiment, the manufacturing process of the casing of electronic device 100 is as follows: in the step S110, a casing body 110 is provided. In the step S120, a surface S1 of the casing body 110 is roughened. In the step S130, an oxide ceramic layer 120 is formed on the surface S1 of the casing body 110. In the step S140, an anti-fingerprint layer 130 is formed on the oxide ceramic layer 120.

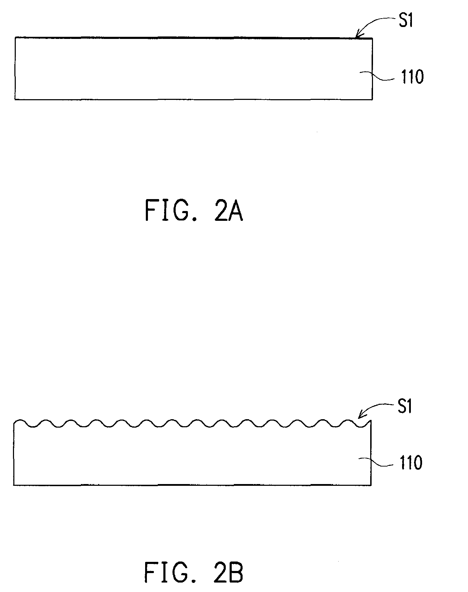

FIG. 2A to FIG. 2D are cross-sectional schematic diagrams of the manufacturing method of the casing of electronic device of FIG. 1. In the embodiment, the casing of electronic device 100 is, for instance, the casing of mobile phones or smart phones, but the application does not limit the scope of the electronic device. FIG. 2A to FIG. 2D sequentially illustrate the manufacturing process of the casing of electronic device 100. The manufacturing process of the casing of electronic device 100 of the embodiment is sequentially explained in the following with FIG. 1 and FIG. 2A to FIG. 2D.

Referring to FIG. 1 and FIG. 2A, first, in the step S110, the casing body 110 is provided. In the embodiment, the material of the casing body 110 is metal, such as aluminum alloys. However, in other embodiments, the material of the casing body may be magnesium alloys, titanium alloys, or other metals, but the application is not limited thereto. Pretreatment process may be applied to the casing body 110, such as cleaning the surface S1 of the casing body 110 to remove grease or impurities.

Referring to FIG. 1 and FIG. 2B, then, in the step S120, the surface S1 of the casing body 110 is roughened. In the embodiment, the casing body 110 is roughened by a sandblasting process for the surface S1 with pretreatment. The material of the sandblast is, for instance, ceramic sand or glass sand, but the application is not limited thereto. Moreover, in other embodiments, the surface S1 of the casing body 110 may be roughened by vapor deposition, or the surface S1 may also not be roughened. The application does not limit the roughening method of the surface S1, and also does not require roughening of the surface S1.

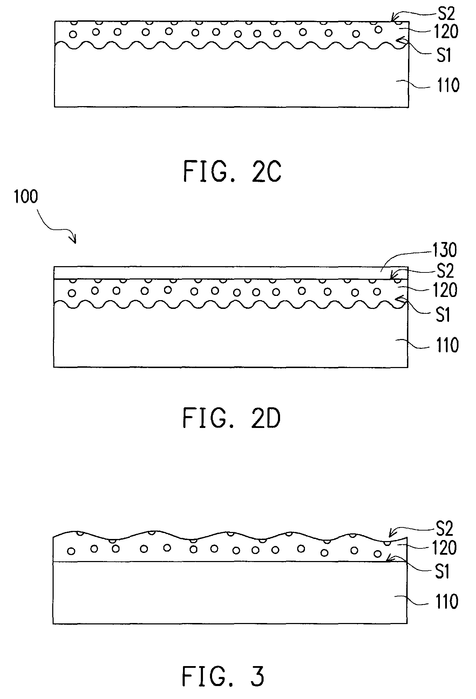

Referring to FIG. 1 and FIG. 2C, then, in the step S130, the oxide ceramic layer 120 is formed on the surface S1 of the casing body 110. In the embodiment, the surface S1 of the casing body 110 is already roughened, and the oxide ceramic layer 120 is formed on the roughened surface S1 of the casing body 110. Therefore, the oxide ceramic layer 120 may have the more smooth surface S2.

However, in other embodiments, the oxide ceramic layer 120 may be formed on the surface S1 of the casing body 110 that has not been roughened. FIG. 3 is a cross-sectional schematic diagram of the casing of electronic device according to another embodiment of the application. Referring to FIG. 3, in the embodiment, the oxide ceramic layer 120 is formed on the surface S1 of the casing body 110 that has not been roughened, so that the oxide ceramic layer 120 produces the uneven surface S2 during the formation. It may be known from FIG. 2C and FIG. 3C that, before forming the oxide ceramic layer 120 on the surface S1 of the casing body 110, the surface S1 is first roughened so that the oxide ceramic layer 120 has a surface S2 more smooth, but the application is not limited thereto.

Referring to FIG. 1 and FIG. 2C, in the embodiment, the step of forming the oxide ceramic layer 120 on the surface S1 of the casing body 110 is a Micro Arc Oxidation (MAO) process. The Micro Arc Oxidation process may form an oxide ceramic layer having a base metal on the surface of the metal object to enhance the mechanical strength of the metal object.

Simply put, after immersing the metal casing body 110 into an electrolyte solution and applying electric current, an oxide thin film layer is produced on the surface S1 of the casing body 110. When the voltage applied to the casing body 110 exceeds the specified critical value, the partial regions of the oxide ceramic layer relatively weak are punctured by the electric current and produce a micro arc discharge phenomenon, resulting in the surface S1 of the casing body 110 producing arc spots or sparks. Then, the partial regions of the oxide ceramic layer punctured by the electric current regenerate a new oxide thin film layer, and another partial regions of the oxide thin film layer relatively weak are punctured by the electric current and produces the micro arc discharge phenomenon. The steps are repeated and the oxide thin film layer forms a uniform oxide ceramic layer 120 on the surface S1 of the casing body 110.

In the embodiment, the values of the process conditions of the Micro Arc Oxidation process are as follows: the solution temperature is between 35 °C and 50 °C, the voltage is between 400 V and 600 V, the thickness is between 15 µm and 25 µm, and the time is between 15 minutes and 25 minutes. The values are selected for the process conditions of the Micro Arc Oxidation process of the embodiment. In other embodiments, the values of the process conditions may be adjusted according to the demand of the Micro Arc Oxidation process, but the application is not limited thereto.

On the other hand, after the oxide ceramic layer 120 is formed on the surface S1 of the casing body 110 by the Micro Arc Oxidation process, the oxide ceramic layer 120 has a colored appearance. The color of the colored appearance of the oxide ceramic layer 120 depends on the material of the electrolyte solution used for the oxide ceramic layer 120 in the Micro Arc Oxidation process. In the embodiment, the colored appearance of the oxide ceramic layer 120 is black, and in other embodiments, depending on the demand of the colored appearance of the casing body 110, the colored appearance of the oxide ceramic layer may be grey, white, or other colors, but the application is not limited thereto.

After forming the oxide ceramic layer 120 on the surface S1 of the casing body 110, the casing of electronic device 100 is largely formed. Therefore, the surface S2 of the oxide ceramic layer 120 may be regarded as the contact surface when the user touches the casing of electronic device 100. The oxide ceramic layer 120 formed by the Micro Arc Oxidation process has irregular voids as shown in FIG. 2C, therefore the surface S2 of the oxide ceramic layer 120 is a matte surface and feels rough. Therefore, in the embodiment, after forming the oxide ceramic layer 120 on the surface S1 of the casing body 110, the casing of electronic device 100 may fill the voids on the surface S2 of the oxide ceramic layer 120 or polish the oxide ceramic layer 120, so that the surface S2 of the oxide ceramic layer 120 is more smooth.

In particular, in the embodiment, after forming the oxide ceramic layer 120 on the surface S1, the casing of electronic device 100 may fill the irregular voids on the surface S2 of the oxide ceramic layer 120 by a sealing process, wherein the filling method includes electroplating a protective material, but the application is not limited thereto. In other embodiments, the casing of electronic device 100 may not fill the voids on the surface S2 to keep the rough feel of the surface S2, but the application is not limited thereto.

Moreover, in the embodiment, after forming the oxide ceramic layer 120 on the surface S1, the surface S2 of the oxide ceramic layer 120 of the casing of electronic device 100 may transform from a matte surface to a glossy surface by polishing, and the glossy surface is more smooth than the matte surface. Therefore, the casing of electronic device 100 may make the surface S2 more smooth by polishing the oxide ceramic layer 120, and the visual effect of the casing of electronic device 100 changes from that of a matte surface to that of a glossy surface. Furthermore, the glossy surface formed on the oxide ceramic layer 120 by polishing is essentially a mirror surface. Therefore, the mirror surface of the oxide ceramic layer 120 may provide the casing of electronic device 100 a different visual effect by reflecting images recognizable by the naked eye. However, in other embodiments, the casing of electronic device 100 may not polish the oxide ceramic layer 120 to keep the matte effect, but the application is not limited thereto.

Referring to FIG. 1 and FIG. 2D, then, in the step S140, the anti-fingerprint layer 130 is formed on the oxide ceramic layer 120, wherein the anti-fingerprint layer 130 may be transparent or light transmissive. In the embodiment, since the user operates the electronic device by holding the casing of electronic device 100, so that fingerprints and dirt from the hands of the user is easily remained in the voids on the surface S2 of the oxide ceramic layer 120. Therefore, the casing of electronic device 100 of the embodiment further includes the anti-fingerprint layer 130 located on the oxide ceramic layer 120, and the contact surface of the casing of electronic device 100 the user touches changes from the surface S2 of the oxide ceramic layer 120 to the anti-fingerprint layer 130, as shown in FIG. 2D. Accordingly, the surface S2 of the oxide ceramic layer 120 is more smooth, and may prevent fingerprints or dirt from remaining on the casing of electronic device 100.

In the embodiment, the step of forming the anti-fingerprint layer 130 on the oxide ceramic layer 120 includes coating the anti-fingerprint coating, such as forming the anti-fingerprint coating on the surface S2 of the oxide ceramic layer 120 by spray coating. Table 1 below explains the ingredients of the anti-fingerprint coating of the embodiment, but the application is not limited thereto, as coatings with other ingredients may also be used in other embodiments.

**Table 1: Ingredients of the Anti-Fingerprint Coating of the Embodiment**

| Ingredient | CAS Number | Content% |
|---|---|---|
| Xylene | 1330-20-7 | 15-25 |
| 2-butoxyethanol | 111-76-2 | 5-15 |
| Methyl ethyl ketone | 78-93-3 | 5-15 |
| Toluene | 108-88-3 | 5-15 |
| 2-methylpropanol | 78-83-1 | 5-15 |
| Ethylbenzene | 100-41-4 | 1-5 |
| Epoxy resin | 25036-25-3 | 1-5 |
| Methyl isobutyl ketone | 108-10-1 | 1-5 |

The surface of the anti-fingerprint layer 130 is more smooth than the surface of the oxide ceramic layer 120, and the anti-fingerprint layer 130 does not affect the texture of the surface S2 of the oxide ceramic layer 120. Therefore, the anti-fingerprint layer 130 may be formed on a polished surface S2 of the oxide ceramic layer 120 so that the casing of electronic device 100 has the visual effect of a glossy surface or even of a mirror surface. The anti-fingerprint layer 130 may also be formed on an unpolished surface S2 of the oxide ceramic layer 120 so that the casing of electronic device 100 has the visual effect of a matte surface.

Since the anti-fingerprint layer 130 is located on the outermost layer of the casing of electronic device 100, so that whether or not the oxide ceramic layer 120 is polished does not affect the tactile effect of the casing of electronic device 100. Therefore, the anti-fingerprint layer 130 may let the casing of electronic device 100 have a more smooth surface, and may prevent fingerprints or dirt from remaining on the casing of electronic device 100.

After forming the anti-fingerprint layer 130 on the oxide ceramic layer 120, the casing of electronic device 100 is complete. Referring to FIG. 2D, in the embodiment, the casing of electronic device 100 includes the casing body 110, the oxide ceramic layer 120, and the anti-fingerprint layer 130. The oxide ceramic layer 120 is located on the surface S1 of the casing body 110 and has a colored appearance, wherein the surface S1 of the casing body 110 is a roughened surface. The anti-fingerprint layer 130 is located on the oxide ceramic layer 120, and the surface of the anti-fingerprint layer 130 is more smooth than the surface of the oxide ceramic layer 120.

The casing of electronic device 100 may be regarded as a bilayer structure composed of the metal casing body 110 and the oxide ceramic layer 120, and the casing of electronic device 100 may also have the anti-fingerprint layer 130 formed on the oxide ceramic layer 120. Compared to the traditional casing of electronic device having the problem of bumping often and becoming cracked or deformed, the casing of electronic device 100 has the oxide ceramic layer 120 to enhance the mechanical strength of the casing of electronic device 100, and has the anti-fingerprint layer 130 to prevent fingerprints or dirt from remaining on the casing of electronic device 100. Accordingly, the appearance, the aesthetics, and the durability of the casing of electronic device 100 are significantly enhanced.

In summary, the application provides a manufacturing method of a casing of electronic device, wherein the oxide ceramic layer having a colored appearance is formed on the metal casing body by the Micro Arc Oxidation process to enhance the mechanical strength and the texture of the casing of electronic device. Moreover, the application further provides a casing of electronic device having an oxide ceramic layer located on the surface of the casing body. Moreover, the casing of electronic device also has the anti-fingerprint layer located on the oxide ceramic layer. The surface of the anti-fingerprint layer is more smooth than the surface of the oxide ceramic layer to prevent fingerprints or dirt from remaining in the voids on the oxide ceramic layer, and has a more smooth tactility. Accordingly, the casing of electronic device has higher mechanical strength and better texture.

Although the application has been described with reference to the above embodiments, it will be apparent to one of the ordinary skill in the art that modifications and variations to the described embodiments may be made without departing from the scope of the application. Accordingly, the scope of the application will be defined by the attached claims not by the above detailed descriptions.

## Claims

1. A manufacturing method of a casing of electronic device, comprising:
providing a casing body, wherein the material of the casing body is metal;
forming an oxide ceramic layer on a surface of the casing body, wherein the step of forming the oxide ceramic layer on the surface of the casing body is a Micro Arc Oxidation (MAO) process; and
forming an anti-fingerprint layer (AFP layer) on the oxide ceramic layer after the step of forming the oxide ceramic layer, **characterized in that**
the AFP layer comprises 15-25% Xylene, 5-15% 2-butoxyethanol, 5-15% Methyl
ethyl ketone, 5-15% Toluene, 5-15% 2-methylpropanol, 1-5% Ethylbenzene, 1-5%
Epoxy resin, 1-5% Methyl isobutyl ketone; and
after the step of providing the casing body, roughening a surface of the casing body,
and the oxide ceramic layer is formed on the roughened surface of the casing body.

2. The method of claim 1, wherein the surface of the AFP layer is more smooth than the surface of the oxide ceramic layer.

3. The method of claim 2, wherein the step of forming the AFP layer on the oxide ceramic layer comprises coating an anti-fingerprint coating.

4. The method of claim 1, further comprising:
filling the voids on the surface of the oxide ceramic layer after the step of forming the oxide ceramic layer.

5. The method of claim 1, further comprising:
polishing the oxide ceramic layer after the step of forming the oxide ceramic layer, so as to transform the surface of the oxide ceramic layer from a matte surface to a glossy surface, wherein the glossy surface is more smooth than the matte surface.

6. The method of claim 5, wherein the glossy surface is a mirror surface.

7. The method of claim 1, wherein the oxide ceramic layer has a colored appearance.

8. A casing of electronic device, comprising:
a casing body, wherein the material of the casing body is metal;
an oxide ceramic layer, located on a surface of the casing body; and
an AFP layer, located on the oxide ceramic layer, **characterized in that** the AFP layer comprises 15-25% Xylene, 5-15% 2-butoxyethanol, 5-15% Methyl ethyl ketone, 5-15% Toluene, 5-15% 2-methylpropanol, 1-5% Ethylbenzene, 1-5% Epoxy resin, 1-5% Methyl isobutyl ketone; and
that the surface of the casing body is a roughened surface.

9. The casing of electronic device of claim 8, wherein the surface of the AFP layer is more smooth than the surface of the oxide ceramic layer.

10. The casing of electronic device of claim 8, wherein the surface of the oxide ceramic layer transforms from a matte surface to a glossy surface after polishing, and the glossy surface is more smooth than the matte surface.

11. The casing of electronic device of claim 10, wherein the glossy surface is a mirror surface.

12. The casing of electronic device of claim 8, wherein the oxide ceramic layer has a colored appearance.

13. The casing of electronic device of claim 12, wherein the colored appearance comprises black, grey, and white.

## Patentansprüche

1. Ein Herstellungsverfahren eines Gehäuses einer elektronischen Vorrichtung, das Folgendes beinhaltet:
Bereitstellen eines Gehäusekörpers, wobei das Material des Gehäusekörpers Metall ist;
Bilden einer Oxidkeramikschicht auf einer Oberfläche des Gehäusekörpers, wobei der Schritt des Bildens der Oxidkeramikschicht auf der Oberfläche des Gehäusekörpers ein Micro-Arc-Oxidation-(MAO)-Vorgang ist; und
Bilden einer Anti-Fingerprint-Schicht (AFP-Schicht) auf der Oxidkeramikschicht nach dem Schritt des Bildens der Oxidkeramikschicht, **dadurch gekennzeichnet, dass** die AFP-Schicht 15-25 % Xylen, 5-15 % 2-Butoxyethanol, 5-15 % Methylethylketon, 5-15 % Toluol, 5-15 % 2-Methylpropanol, 1-5 % Ethylbenzen, 1-5 % Epoxidharz, 1-5 % Methylisobutylketon beinhaltet; und
nach dem Schritt des Bereitstellens des Gehäusekörpers eine Oberfläche des Gehäusekörpers geraut wird und die Oxidkeramikschicht auf der gerauten Oberfläche des Gehäusekörpers gebildet wird.

2. Verfahren gemäß Anspruch 1, wobei die Oberfläche der AFP-Schicht glatter als die Oberfläche der Oxidkeramikschicht ist.

3. Verfahren gemäß Anspruch 2, wobei der Schritt des Bildens der AFP-Schicht auf der Oxidkeramikschicht das Beschichten einer Anti-Fingerprint-Schicht beinhaltet.

4. Verfahren gemäß Anspruch 1, das ferner Folgendes beinhaltet:
Füllen der Fehlstellen auf der Oberfläche der Oxidkeramikschicht nach dem Schritt des Bildens der Oxidkeramikschicht.

5. Verfahren gemäß Anspruch 1, das ferner Folgendes beinhaltet:
Polieren der Oxidkeramikschicht nach dem Schritt des Bildens der Oxidkeramikschicht, um die Oberfläche der Oxidkeramikschicht von einer matten Oberfläche in eine glänzende Oberfläche umzuwandeln, wobei die glänzende Oberfläche glatter als die matte Oberfläche ist.

6. Verfahren gemäß Anspruch 5, wobei die glänzende Oberfläche eine Spiegeloberfläche ist.

7. Verfahren gemäß Anspruch 1, wobei die Oxidkeramikschicht ein farbiges Erscheinungsbild aufweist.

8. Ein Gehäuse einer elektronischen Vorrichtung, das Folgendes beinhaltet:
einen Gehäusekörper, wobei das Material des Gehäusekörpers Metall ist;
eine Oxidkeramikschicht, befindlich auf einer Oberfläche des Gehäusekörpers; und
eine AFP-Schicht, befindlich auf der Oxidkeramikschicht, **dadurch gekennzeichnet,**
**dass**
die AFP-Schicht 15-25 % Xylen, 5-15 % 2-Butoxyethanol, 5-15 % Methylethylketon,
5-15 % Toluol, 5-15 % 2-Methylpropanol, 1-5 % Ethylbenzen, 1-5 % Epoxidharz, 1-5 % Methylisobutylketon beinhaltet; und
**dass** die Oberfläche des Gehäusekörpers eine geraute Oberfläche ist.

9. Gehäuse einer elektronischen Vorrichtung gemäß Anspruch 8, wobei die Oberfläche der AFP-Schicht glatter als die Oberfläche der Oxidkeramikschicht ist.

10. Gehäuse einer elektronischen Vorrichtung gemäß Anspruch 8, wobei die Oberfläche der Oxidkeramikschicht nach dem Polieren von einer matten Oberfläche in eine glänzende Oberfläche umgewandelt ist, und die glänzende Oberfläche glatter als die matte Oberfläche ist.

11. Gehäuse einer elektronischen Vorrichtung gemäß Anspruch 10, wobei die glänzende Oberfläche eine Spiegeloberfläche ist.

12. Gehäuse einer elektronischen Vorrichtung gemäß Anspruch 8, wobei die Oxidkeramikschicht ein farbiges Erscheinungsbild aufweist.

13. Gehäuse einer elektronischen Vorrichtung gemäß Anspruch 12, wobei das farbige Erscheinungsbild schwarz, grau und weiß beinhaltet.

## Revendications

1. Une méthode de fabrication d'un boîtier de dispositif électronique, comprenant :
le fait de fournir un corps de boîtier, où le matériau du corps de boîtier est du métal ;
le fait de former une couche de céramique d'oxyde sur une surface du corps de boîtier, où l'étape consistant à former la couche de céramique d'oxyde sur la surface du corps de boîtier est un procédé d'oxydation micro arc (MAO, Micro Arc Oxidation) ; et
le fait de former une couche anti-empreintes digitales (couche AFP, Anti-FingerPrint) sur la couche de céramique d'oxyde après l'étape consistant à former la couche de céramique d'oxyde, **caractérisée en ce que**
la couche AFP comprend de 15 à 25 % de xylène, de 5 à 15 % de 2-butoxyéthanol, de 5 à 15 % de méthyl éthyl cétone, de 5 à 15 % de toluène, de 5 à 15 % de 2-méthylpropanol, de 1 à 5 % d'éthylbenzène, de 1 à 5 % de résine époxy, de 1 à 5 % de méthyl isobutyl cétone ; et
après l'étape consistant à fournir le corps de boîtier, le fait de rugosifier une surface du corps de boîtier, et la couche de céramique d'oxyde est formée sur la surface rugosifiée du corps de boîtier.

2. La méthode de la revendication 1, où la surface de la couche AFP est plus lisse que la surface de la couche de céramique d'oxyde.

3. La méthode de la revendication 2, où l'étape consistant à former la couche AFP sur la couche de céramique d'oxyde comprend le fait de déposer un revêtement anti-empreintes digitales.

4. La méthode de la revendication 1, comprenant en sus :
le fait de remplir les vides sur la surface de la couche de céramique d'oxyde après l'étape consistant à former la couche de céramique d'oxyde.

5. La méthode de la revendication 1, comprenant en sus :
le fait de polir la couche de céramique d'oxyde après l'étape consistant à former la couche de céramique d'oxyde, de manière à transformer la surface de la couche de céramique d'oxyde d'une surface mate à une surface brillante, où la surface brillante est plus lisse que la surface mate.

6. La méthode de la revendication 5, où la surface brillante est une surface miroir.

7. La méthode de la revendication 1, où la couche de céramique d'oxyde a un aspect

8. Un boîtier de dispositif électronique, comprenant :
un corps de boîtier, où le matériau du corps de boîtier est du métal ;
une couche de céramique d'oxyde, située sur une surface du corps de boîtier ; et
une couche AFP, située sur la couche de céramique d'oxyde, **caractérisé en ce que** la couche AFP comprend de 15 à 25 % de xylène, de 5 à 15 % de 2-butoxyéthanol, de 5 à 15 % de méthyl éthyl cétone, de 5 à 15 % de toluène, de 5 à 15 % de 2-méthylpropanol, de 1 à 5 % d'éthylbenzène, de 1 à 5 % de résine époxy, de 1 à 5 % de méthyl isobutyl cétone ; et
**en ce que** la surface du corps de boîtier est une surface rugosifiée.

9. Le boîtier de dispositif électronique de la revendication 8, où la surface de la couche AFP est plus lisse que la surface de la couche de céramique d'oxyde.

10. Le boîtier de dispositif électronique de la revendication 8, où la surface de la couche de céramique d'oxyde se transforme d'une surface mate à une surface brillante après polissage, et la surface brillante est plus lisse que la surface mate.

11. Le boîtier de dispositif électronique de la revendication 10, où la surface brillante est une surface miroir.

12. Le boîtier de dispositif électronique de la revendication 8, où la couche de céramique d'oxyde a un aspect coloré.

13. Le boîtier de dispositif électronique de la revendication 12, où l'aspect coloré comprend le noir, le gris, et le blanc.
